# EUROPEAN PATENT SPECIFICATION

(11) **EP 3 941 172 B1**
(45) Date of publication and mention of the grant of the patent: **24.01.2024**
(21) Application number: 20186153.1
(22) Date of filing: 16.07.2020
(51) Int. Cl.: H05K 7/20

(54) **ELECTRONIC COMPONENT WITH COOLING CLEARANCE, AND ASSEMBLY METHOD**
ELEKTRONISCHE KOMPONENTE MIT KÜHLUNGSFREIRAUM UND MONTAGEVERFAHREN
COMPOSANT ÉLECTRONIQUE DOTÉ D'UN JEU DE REFROIDISSEMENT ET PROCÉDÉ D'ASSEMBLAGE

(43) Date of publication of application: 19.01.2022
(73) Proprietor: TE Connectivity Germany GmbH, 64625 Bensheim (DE); TE Connectivity Solutions GmbH, 8200 Schaffhausen (CH)
(72) Inventor: Hangauer, Andreas, 64625 Bensheim (DE); Kosch, Bernd, 64625 Bensheim (DE); Sarraf, David Bruce, Middletown, PA 17057 (US)
(74) Representative: Grünecker Patent- und Rechtsanwälte PartG mbB

(56) References cited:
- DE-A1- 2 621 705
- FR-A1- 2 722 054
- US-B1- 6 449 159

## Description

The present invention relates to an electronic component comprising at least one heat generating electronic element and to a method of assembling such an electronic component.

Electronic components with electronic elements generating critical amounts of heat when in operation can for instance be found in the field of switching high currents and/or voltages, in particular in a vehicle. With the increase in heat dissipation from microelectronics devices and the reduction in overall form factors, thermal management becomes a more a more important element of electronic product design.

Both the performance reliability and life expectancy of electronic equipment are inversely related to the component temperature of the equipment. The relationship between the reliability and the operating temperature of a typical silicon semi-conductor device shows that a reduction in the temperature corresponds to an exponential increase in the reliability and life expectancy of the device. Therefore, long life and reliable performance of a component may be achieved by effectively controlling the device operating temperature within the limits set by the device design requirements.

Traditional electronic components having heat generating electronic elements (such as power switches) are usually equipped with heat sinks for handling the excessive heat. A heat sink is a passive heat exchanger that transfers the heat generated by an electronic or a mechanical device to a fluid medium, often air or a liquid coolant, where it is dissipated away from the device, thereby allowing regulation of the device's temperature. In the following, air is assumed to be the cooling fluid. In most situations, heat transfer across the interface between the solid surface and the coolant air is the least efficient within the system, and the solid-air interface represents the greatest barrier for heat dissipation. A heat sink lowers this barrier mainly by increasing the surface area that is in direct contact with the coolant. This allows more heat to be dissipated and/or lowers the device operating temperature. The primary purpose of a heat sink is to maintain the device temperature below the maximum allowable temperature.

Heat sinks are usually fabricated from a highly thermally conductive material, mainly metal. However, the assembly of a metal heat sink close to the heat generating electronic elements is time consuming, costly and requires a significant amount of extra installation space. Moreover, the total weight of the electronic component is substantially increased.

FR 2 722 054 A1 relates to a protection casing with cooling canal for electronic components in automotive applications. The casing includes a number of walls delimiting an inner cavity. A lid covers the casing. A flexible pcb with a number of electronic components is placed inside the cavity. The pcb is connected to a connector placed on one of the casing walls. A canal is provided in the lid. The canal runs from the lid surface towards the casing opposite wall, inside its cavity. Air is circulated through the canal to ensure its cooling.

US 6 449 159 B1 relates to a semiconductor module comprising a heat spreader, at least two semiconductors thermally coupled to the heat spreader, and a plurality of electrically conductive leads electrically connected to the semiconductors. The leads may form part of a flexible circuit at least partially attached to the heat spreader, where at least one of the electrically conductive leads is preferably common to both of the semiconductors.

DE 26 21 705 A1 relates to a heat sink block for a flexible printed circuit, comprising a rectangular frame with enclosed ventilation channels running across it. The flexible printed circuit is folded in zig-zag fashion and the folds inserted in the spaces between the ventilation channels. Circuit chips are attached to one face of the flexible printed circuit, which is folded so that the circuit chips lie against the walls of the heat sink block.

A need remains for an electronic component and an assembly method that allow for an efficient heat management and at the same time only require minimal installation space to fit space requirements of the envisaged application. Advantageously, the electronic component can be fabricated economically.

At least one of these objectives is solved by the subject matter of the independent claims. Advantageous embodiments of the present invention are the subject matter of the dependent claims.

The present invention is based on the idea to fold the circuit carrier in a manner that two distinct opposing sections are generated and to design the housing so that it closely encompasses each of the sections separately. Thus, a cooling clearance, which may also be referred to as a cooling channel or cooling chimney, can be provided between the two sections. This cooling clearance can be filed with any type of suitable cooling fluid, such as air, but also a liquid coolant solution. For instance, in case of an electronic relay, the first section may comprise the heat generating electronic components, such as semiconductor switches (e. g. MOSFETs or IGBTs), whereas the second section may comprise a signal processing unit. Thereby, the heat generated by the switching losses of the semiconductor switches is not affecting the signal processing components. Furthermore, when arranging the circuit carrier unit such that the heat generating electronic components face the cooling clearance and by ensuring that the cooling clearance is small enough to not allow larger objects enter into it, an effective touch protection against heated surfaces can be achieved.

According to an advantageous example of the present disclosure, the circuit carrier unit further comprises a base section connecting the first and the second section. Such a distinct base section can advantageously be used for arranging connecting elements thereon, which allow the connection to external components, such as an electrical connector proving power lines and signal lines in case of an electronic relay.

Furthermore, the circuit carrier unit may further comprise flexible hinge elements connecting the base section to the first and/or the second section. Such hinge elements allow the fabrication of the circuit carrier unit including the assembly of all electronic components on a two-dimensional board and the subsequent folding before the assembly inside the housing. The flexible hinge elements may comprise foil hinges fabricated from a plastic material or a flexible foil cable (FFC). Of course, also other hinge techniques, such as multipart bearing hinges from every suitable material can also be used to hold together the sections of the circuit carrier unit.

In order to facilitate the assembly process, the circuit carrier unit may have a U-shaped cross-section, the first section and the second section forming a first and a second leg, respectively, extending from the base section, and wherein the first and the second receiving portion are formed by two parallel slots. The first and second sections can thus be slid into the belonging first and the second receiving portions in one simultaneous step.

According to advantageous examples of the present disclosure, the circuit carrier unit comprises a printed circuit board (PCB) and/or a flexible printed circuit (FPC) and/or a direct copper bonded (DCB) ceramic substrate, and/or a direct aluminum bonded (DAB) ceramic substrate.

Printed circuit boards (PCB) can be fabricated from many different materials, depending on the required properties, such as electrical behavior or thermo-mechanical properties. In most cases, an electrically insulating material (e. g. epoxy with glass fiber) is combined with electrically conductive layers (e. g. copper), often in a multilayer structure. PCBs can be rigid or flexible. Flexible PCBs are in the following referred to as flexible printed circuits. For instance, flexible printed circuits (FPC) are made with a photolithographic technology. An alternative way of making flexible foil circuits or flexible flat cables (FFCs) is laminating very thin copper strips in between two layers of plastic material, such as PET.

DCB stands for Direct Copper Bonding and denotes a process in which copper and a ceramic material are fused together at high temperatures. For instance, two layers of copper are directly bonded to an aluminum oxide or aluminum nitride ceramic base. In particular, known power modules have been designed with DCB substrates. The DCB process yields a thin base and eliminates the need for thick, heavy copper bases that were used in the past. Because modules with DCB bases use fewer layers, they have much lower thermal resistance values and much better power cycling capabilities. DCB ceramic substrates have high mechanical strength and mechanical stability, good adhesion and corrosion resistance, excellent electrical insulation and thermal conductivity, as well as thermal cycling stability. Further, they have a matched thermal expansion coefficient to that of silicon (Si) and gallium arsenide (GaAs), or other semiconductor materials, and a good heat spreading.

The copper pattern providing the electrical interconnection is strong enough to handle high currents. The excellent thermal conductivity allows to place power semiconductor chips in very close proximity. This results in more power per unit of volume and improved reliability of a power system.

Furthermore, there exist also so-called direct aluminum bonded substrates (DAB), which use aluminum instead of copper as the electrically conductive material. The lower weight and better thermal cycling performance of DAB make them ideal for automotive, aerospace, and other high reliability applications.

Further, DCB/DAB is the basis for the "chip-on-board" technology which is the packaging trend for the next generation integrated power electronic components.

According to the present disclosure, the clearance is formed by a blind cavity with a closed bottom region and an opening for ingress of a cooling medium. This construction allows for an optimum thermal contact between the heat generating electronic element and the cooling medium on the one hand, and a safe sealing of the complete circuitry to ensure protection against touch and ingress of solid particles and liquid.

In order to generate a flow of cooling fluid along the surface of the housing that is close to the circuit carrier unit, this blind cavity has at least one venting aperture which is arranged distanced apart from the opening. The at least one venting aperture may be positioned close to the bottom of the blind cavity, so that it can additionally serve as a draining means for letting out liquids (such as condensed water).

Additionally, the blind cavity may further comprise a plurality of cooling ribs which extend along the blind cavity from the opening towards the bottom region. In particular with a venting aperture, the ribs lead to a more or less laminar cooling fluid flow, thereby improving the heat dissipation. Moreover, the active thermal interface is enlarged by such cooling ribs (or fins).

According to a further advantageous the electronic component may further comprise a connector interface for electrically contacting the at least one electronic element. In case the electronic component is an electronic relay, the connector interface is needed for connecting the electronic component to the power lines and to the signal lines which provide the control signals for controlling the operation of the at least one electronic element. For instance, the connector interface may comprise a plurality of electrically conductive contact elements. This allows the connector interface being part of a plug connector and to be contacted by a mating connector element. In particular, the electrically conductive contact elements may comprise press-fit pins which are connected to the circuit carrier unit via a press-fit connection. However, also a solder or welded connection can be employed. The conductive contact elements may either have the shape of pin contacts or tab (flat-) contacts which can be inserted into matching contact receptacles, or they may be formed as contact receptacles or fork contacts for receiving matching pin or tab contacts.

Advantageously, the housing may comprise a base body and a cover element, wherein the cover element is attached to the base body so that the circuit carrier unit is enclosed in a sealed manner. Thus, neither the circuit carrier unit nor any electronic element arranged inside the housing makes physical contact with the environment outside the housing. Such a protection by a sealed inner volume of the housing is a particular need for the challenging environment of automotive applications.

The inventive heat management can in particular be advantage if the at least one electronic element comprises a power switching element, such as a MOSFET or an IGBT, or another semiconductor switch.

In order to enhance the mechanical stability under the influence of vibrations, the housing may at least partly be filled with a potting material that covers at least a part of the circuit carrier unit. To this end the housing may comprise a filling aperture which can be covered by a sealing plug or blind plug after the potting material has been filled in and cured to its final consistency.

The present invention further provides a method for assembling an electronic unit according to the present disclosure, the method comprising the following steps:
providing a circuit carrier unit, wherein at least one electronic element is assembled on the circuit carrier unit,
providing a protective housing, and
inserting the circuit carrier unit at least partly into the housing,
wherein the circuit carrier unit has a first section and a second section, the second section being arranged at a distance from the first section and opposing to the first section; and
wherein the housing has a first receiving portion for receiving the first section and a second receiving portion for receiving the second section, and wherein the first receiving portion and the second receiving portion are separated from each other by a cooling clearance.

In particular, the first section and the second section may be inserted into the respective first and second receiving portions simultaneously. This allows a particularly fast and economic assembly. The accompanying drawings are incorporated into the specification and form a part of the specification to illustrate several embodiments of the present invention. These drawings, together with the description, serve to explain the principles of the invention. The drawings are merely for the purpose of illustrating the preferred and alternative examples of how the invention can be made and used and are not to be construed as limiting the invention to only the illustrated and described embodiments. Further features and advantages will become apparent from the following more particular description of the various embodiments of the invention as illustrated in the accompanying drawings, in which like references refer to like elements, and wherein:
- **FIG. 1**: is a schematic perspective view of an electronic component according to a first aspect of the present disclosure;
- **FIG. 2**: is a perspective, partly exploded view of the electronic component of FIG. 1;
- **FIG. 3**: is a perspective sectional view of the electronic component of FIG. 1;
- **FIG. 4**: is another perspective sectional view of the electronic component of FIG. 1.

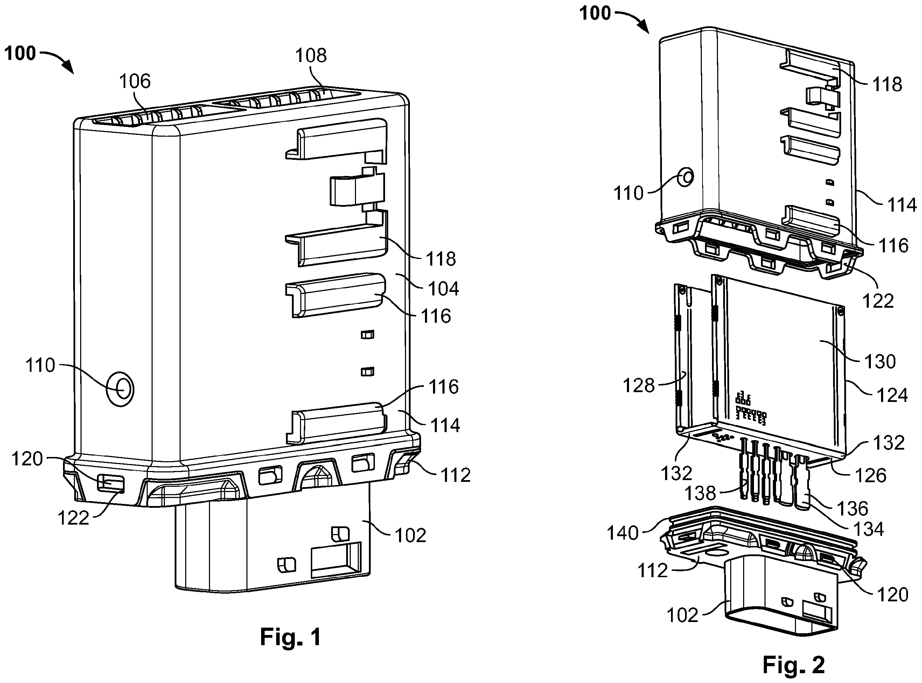

The present invention will now be explained in more detail with reference to the Figures. Referring to Fig. 1, a schematic perspective view of an electronic component is shown for an electronic relay module. Although in the following only the example of a solid state switching module having MOSFET switches as the heat generating electronic components, it is clear that the principles of the present invention are of course also applicable for any other type of electronic element which needs efficient cooling in a restricted installation space.

As shown in Fig. 1, an electronic component 100 may for instance be a switching module which is connected via a connector interface element 102 to an external matching plug connector (not shown in the Figures). The electronic component 100 comprises a housing 104 which is fabricated from an electrically insulating, but thermally conductive material. As will become apparent from the following drawings, the housing 104 encompasses as a circuit carrier unit. The housing 104 comprises a cooling chimney 106 which can also be referred to as a "cooling channel" or "cooling clearance". The cooling chimney 106 is formed as a blind cavity with an opening 108 on the upper side of Fig. 1 and a bottom region on the lower side of Fig. 1 (not visible in this Fig.).

Close to the bottom area of the blind cavity, two venting apertures 110 are provided. Thus, from the opening 108 towards the venting apertures 110, a flow channel is formed through which a cooling fluid, e. g. air or a cooling liquid, can move, thus dissipating the heat generated by the electronic elements inside the housing 104.

According to the shown example, the housing 104 comprises a base body 112 (sometimes also referred to as "header") and a cover element 114, which are sealingly connected to each other to enclose the circuit carrier unit in a watertight manner. The base body 112 and the cover element 114 are mechanically fixed at each other by means of a plurality of snap hooks 120 and snap fit recesses 122. However, the two parts can also be fitted together using ultrasonic or laser welding or gluing. Furthermore, it is clear that also more than two separately manufactured housing elements can be provided that are fit together to form the final enclosure of the housing 104. For instance, the cover element 114 may further be divided into two half-shells.

Furthermore, the housing 104 as shown is provided with guides 116 and guiding clips 118 for attaching the electronic component to an external unit, e. g. the housing of a motor.

Fig. 2 shows the electronic component 100 of Fig. 1 in an exploded view. As can be seen from this Figure, the circuit carrier unit 124 has an essentially U-shaped cross-section with a base section 126, a first section 128, and a second section 130. The first and the second sections 128, 130 extend away from the base section 126. Foil hinges 132 interconnect the first section 128 and the second section 130 with the base section 126. Thus, the circuit carrier unit 124 can be produced and assembled with the electronic elements thereon as a flat two-dimensional board and can be folded later to be inserted into the cover element 114 of the housing 104. Of course, the complete circuit carrier unit 124 may also be a flexible flat circuit board assembly, which is bent along suitable folding lines forming a hinge means.

The first section 128 may for instance be a power side, carrying high power MOSFETs which handle currents up to 20 A. The overall loss then amounts to around 2 W. The second section 130 advantageously is the signal and communication side.

The base section 126 is provided with electrically conductive leads (not visible in the Figure) which are connected to electrically conductive contact elements 134. In particular, for carrying a higher electrical current, the wider flat-contacts 136 are provided as power contacts, whereas the smaller flat-contacts 138 are provided as signal contacts.

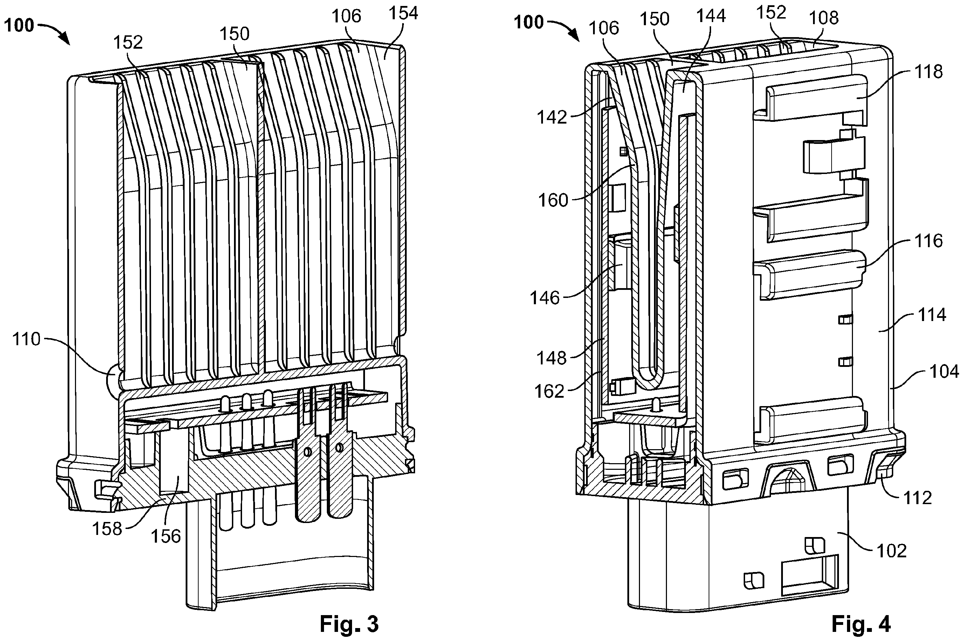

As will become more apparent from the following Figure 4, the first section 128 of the circuit carrier unit 124 is populated with the heat generating electronic elements, specifically the power switches. Opposite to the first section 128, the second section 130 carries the electronic elements which produce less heat, but are sensitive towards heat, namely the signal processing circuitry. As will become more apparent from Figures 3 and 4, each section 128, 130 is held in a separate compartment of the housing 104, both compartments separated from each other by the cooling chimney 106.

Advantageously, by dividing the circuit board into two areas, one being a power side and the other being a signal side, an improved heat dissipation and additionally a touch protection can be achieved. Furthermore, the cover element can be fabricated from a cost-efficient plastic material.

Around the circumference of the base body 112, sealing means 140 (for instance a sealing lip, integrally formed from the housing material and/or a silicone sealing lip) are provided to seal the interface between the base body 112 and the cover element 114.

Two sectional views of the electronic component 100 are shown in Figures 3 and 4 and will now be explained in detail.

As can best be seen from Fig. 4, the first section 128 and the second section 130 are received in respective first and second receiving portions 142, 144 which are forming separate inner compartments of the housing 104. The electronic elements 146 are assembled on a substrate 148 in a manner that at least the elements radiating the highest amount of heat are oriented towards the cooling clearance 106.

The cooling clearance 106 is designed as two blind cavities separated by a separation wall 150. It has to be noted that the separation wall 150 is optional.

Furthermore, the cooling clearance 106 is provided with a plurality of cooling ribs (or fins) 152 for enlarging the surface that comes into contact with the cooling fluid, e. g. air. The cooling ribs 152 may have any suitably cross-section, for instance a V-shaped tapered cross-section. Moreover, the cooling ribs 152 may be provided in an arbitrary number on the inside and/or the outside of one or both of the walls 160 of the cooling chimney 106, which oppose the circuit carrier unit 124.

As may be derived from Fig. 3 and 4, the cooling chimney 106 has a funnel shaped peripheral area 154 for forming an enlarged opening 108 that facilitates the heated air to escape from the cooling chimney 106. On the other hand, the cooling chimney 106 has dimensions that are small enough to inhibit the access of a larger object (such as a finger). Thus, an effective touch protection can be achieved because the hot area is not accessible for the user.

For intaking cooler air, the venting apertures 110 are provided at the bottom of the blind cavity forming the cooling chimney 106. When in operation, heat is generated by the electronic element(s) and the air inside cooling clearance 106 is heated up. Due to natural convection in the chimney, that warm air flows towards the upper end of the cooling clearance 106. At the same time cool air is drawn into the venting apertures 110, so that a steady flow of cooling medium dissipates the heat. Of course, also a forced flow of the cooling medium by means of a ventilator or a pump can be used for cooling the electronic component 100.

As mentioned above, the cooling medium does not have to be gaseous, like air, but can also be a liquid, like the cooling liquid used in a vehicle.

Optionally, the inner volume of the housing 104 may also be at least partly filled with a potting material. Such a potting material is filled in as a fluid precursor material and is cured to reach a hardened state. For filling in the fluid precursor material, the base body 112 has a filling aperture 156, which is opened by removing the web 158 (forming a closing cap), and which can be covered by a sealing plug or blind plug (not shown in the Figures) after the potting material has been filled in and has hardened to its final consistency. The potting material improves the cooling effect and, furthermore, mechanically stabilizes the circuit carrier unit inside the housing against vibrations.

Furthermore, an additional layer of thermal interface material (TIM) 162 can be arranged between the circuit carrier unit and housing on one or both surfaces of the circuit carrier. Moreover, guiding ribs may be arranged at the inside of the first and/or second receiving portions 142, 144 in order to facilitate mounting the circuit carrier unit 124 and to secure it inside the housing.

In summary, the present disclosure provides an electronic component which allows an efficient heat management even in constricted spaces, the exterior volume and outer dimensions of the package being maintained. The ingress protection sealing is not impaired by the improvement in heat dissipation.

A heat-developing circuit board in a plastic cover can be cooled effectively by separating the circuit board into at least two areas, a power side and a signal side. Touch protection can be achieved on the hot side for a user without significantly increasing the outer dimensions of the electronic component.

Instead of the conventional cover that does not provide sufficient surface area for heat dissipation, the present disclosure proposes a cover that is divided into two regions by introducing a chimney through which the surface area is increased and additional ventilation is provided by air circulation through side vents. These vents may also serve as drainage holes. The chimney allows the internally generated heat to be dissipated quickly and efficiently to the outside and the user is protected from touching the hot surface.

Additionally, an arbitrary number of cooling ribs with various cross-section, e. g. V-shaped, can be arranged on the inside and/or the outside of the wall forming the chimney.

Optionally, additional cooling can be achieved by at least partly enclosing the heat generating electronic elements by a potting material filled into the housing.

### REFERENCE NUMERALS

| **Reference Numeral** | **Description** |
|---|---|
| 100 | Electronic component |
| 102 | Connector interface element |
| 104 | Housing |
| 106 | Cooling chimney (cooling clearance) |
| 108 | Opening of blind cavity |
| 110 | Venting aperture |
| 112 | Base body |
| 114 | Cover element |
| 116 | Guides |
| 118 | Guiding clips |
| 120 | Snap hook |
| 122 | Snap fit recess |
| 124 | Circuit carrier unit |
| 126 | Base section |
| 128 | First section of circuit carrier unit |
| 130 | Second section of circuit carrier unit |
| 132 | Foil hinge |
| 134 | Contact element |
| 136 | Power contact (flat-contact) |
| 138 | Signal contact (contact pin) |
| 140 | Sealing means |
| 142 | First receiving portion |
| 144 | Second receiving portion |
| 146 | Electronic element |
| 148 | Substrate |
| 150 | Separation wall |
| 152 | Cooling rib |
| 154 | Peripheral area |
| 156 | Filling aperture |
| 158 | Web |
| 160 | Walls of the cooling chimney |
| 162 | Thermal interface material, TIM |

## Claims

1. Electronic component (100) comprising:
a circuit carrier unit (124), wherein at least one electronic element (146) is assembled on the circuit carrier unit (124), and
a protective housing (104) for encompassing the circuit carrier unit (124) at least partly,
wherein the circuit carrier unit (124) has a first section (128) and a second section (130),
the second section (130) being arranged at a distance from the first section (128) and opposing to the first section (128),
wherein the housing (104) has a first receiving portion (142) for receiving the first section (128) and a second receiving portion (144) for receiving the second section (130), and wherein the first receiving portion (142) and the second receiving portion (144) are separated from each other by a cooling clearance (106), and **characterised in that**
the cooling clearance (106) is formed by at least one blind cavity with a closed bottom region and an opening (108) for the passing of a cooling medium, wherein the at least one blind cavity has at least one venting aperture (110) which is arranged distanced apart from the opening (108).

2. Electronic component according to claim 1, wherein the circuit carrier unit (124) further comprises a base section (126) connecting the first section (128) and the second section (130).

3. Electronic component according to claim 2, wherein the circuit carrier unit (124) further comprises flexible hinge elements (132) connecting the base section (126) to the first section (128) and/or the second section (130).

4. Electronic component according to claim 2 or 3, wherein the circuit carrier unit (124) has a U-shaped cross-section, the first section (128) and the second section (130) forming a first and a second leg, respectively, extending from the base section (126), and wherein the first receiving portion (142) and the second receiving portion (144) are formed by two parallel slots.

5. Electronic component according to one of the preceding claims, wherein the circuit carrier unit (124) comprises a printed circuit board, PCB, and/or a flexible printed circuit, FPC, and/or a direct copper bonded, DCB, ceramic substrate, and/or a direct aluminum bonded, DAB, ceramic substrate.

6. Electronic component according to any one of the proceeding claims, further comprising a plurality of cooling ribs (152) which extend along the at least one blind cavity from the opening towards the bottom region

7. Electronic component according to one of the preceding claims, further comprising a connector interface (102) for electrically contacting the at least one electronic element (146).

8. Electronic component according to claim 7, wherein the connector interface (102) comprises a plurality of electrically conductive contact elements (134).

9. Electronic component according to claim 8, wherein the electrically conductive contact elements (134) comprise press-fit pins which are connected to the circuit carrier unit (124).

10. Electronic component according to one of the preceding claims, wherein the housing (104) comprises a base body (112) and a cover element (114), wherein the cover element (114) is attached to the base body (112) so that the circuit carrier unit (124) is enclosed in a sealed manner.

11. Electronic component according to one of the preceding claims, wherein the at least one electronic element (146) comprises a power switching element.

12. Electronic component according to one of the preceding claims, wherein the housing (104) is at least partly filled with a potting material that covers at least a part of the circuit carrier unit (124).

13. Method for assembling an electronic component according to one of the preceding claims, the method comprising the following steps:
providing a circuit carrier unit (124), wherein at least one electronic element (146) is assembled on the circuit carrier unit (124),
providing a protective housing (104), and
inserting the circuit carrier unit (124) at least partly into the housing (104),
wherein the circuit carrier unit (124) has a first section (128) and a second section (130), the second section (130) being arranged at a distance from the first section (128) and opposing to the first section (128); and
wherein the housing (104) has a first receiving portion (142) for receiving the first section (128) and a second receiving portion (144) for receiving the second section (130), and wherein the first receiving portion (142) and the second receiving portion (144) are separated from each other by a cooling clearance (106).

14. Method according to claim 13, wherein the first section (128) and the second section (130) are inserted into the respective first and second receiving portions (142, 144) simultaneously.

## Patentansprüche

1. Elektronische Komponente (100), die umfasst:
eine Schaltungsträger-Einheit (124), wobei wenigstens ein elektronisches Element (146) an der Schaltungsträger-Einheit (124) montiert ist; sowie
ein Schutzgehäuse (104), mit dem die Schaltungsträger-Einheit (124) wenigstens teilweise umschlossen ist,
wobei die Schaltungsträger-Einheit (124) einen ersten Teilabschnitt (128) sowie einen zweiten Teilabschnitt (130) aufweist, der zweite Teilabschnitt (130) in einem Abstand zu dem ersten Teilabschnitt (128) angeordnet ist und dem ersten Teilabschnitt (128) gegenüberliegt,
das Gehäuse (104) einen ersten Aufnahmeabschnitt (142) zum Aufnehmen des ersten Teilabschnitts (128) sowie einen zweiten Aufnahmeabschnitt (144) zum Aufnehmen des zweiten Teilabschnitts (130) aufweist, und
der erste Aufnahmeabschnitt (142) und der zweite Aufnahmeabschnitt (144) durch einen Kühl-Zwischenraum (106) voneinander getrennt sind, und
**dadurch gekennzeichnet, dass**
der Kühl-Zwischenraum (106) durch wenigstens einen Blind-Hohlraum mit einem geschlossenen Bodenbereich sowie einer Öffnung (108) zum Hindurchtreten eines Kühlmediums gebildet wird, wobei der wenigstens eine Blind-Hohlraum wenigstens eine Entlüftungsöffnung (110) aufweist, die von der Öffnung (108) beabstandet angeordnet ist.

2. Elektronische Komponente nach Anspruch 1, wobei die Schaltungsträger-Einheit (124) des Weiteren einen Basis-Teilabschnitt (126) umfasst, der den ersten Teilabschnitt (128) und den zweiten Teilabschnitt (130) verbindet.

3. Elektronische Komponente nach Anspruch 2, wobei die Schaltungsträger-Einheit (124) des Weiteren flexible Scharnier-Elemente (132) umfasst, die den Basis-Teilabschnitt (126) mit dem ersten Teilabschnitt (128) und/oder dem zweiten Teilabschnitt (130) verbinden.

4. Elektronische Komponente nach Anspruch 2 oder 3, wobei die Schaltungsträger-Einheit (124) einen U-förmigen Querschnitt hat, der erste Teilabschnitt (128) und der zweite Teilabschnitt (130) einen ersten bzw. einen zweiten Schenkel bilden, die sich von dem Basis-Teilabschnitt (126) aus erstrecken, und der erste Aufnahmeabschnitt (142) sowie der zweite Aufnahmeabschnitt (144) durch zwei parallele Schlitze gebildet werden.

5. Elektronische Komponente nach einem der vorangehenden Ansprüche, wobei die Schaltungsträger-Einheit (124) eine Leiterplatte und/oder eine flexible gedruckte Schaltung und/oder ein DCB (direct copper bonded)-Keramiksubstrat und/oder ein DAB (direct aluminum bonded)-Keramiksubstrat umfasst.

6. Elektronische Komponente nach einem der vorangehenden Ansprüche, die des Weiteren eine Vielzahl von Kühlrippen (152) umfasst, die sich entlang des wenigstens einen Blind-Hohlraums von der Öffnung in Richtung des Bodenbereiches erstrecken.

7. Elektronische Komponente nach einem der vorangehenden Ansprüche, die des Weiteren eine Verbinder-Schnittstelle (102) zum elektrischen Kontaktieren des wenigstens einen elektronischen Elementes (146) umfasst.

8. Elektronische Komponente nach Anspruch 7, wobei die Verbinder-Schnittstelle (102) eine Vielzahl elektrisch leitender Kontakt-Elemente (134) umfasst.

9. Elektronische Komponente nach Anspruch 8, wobei die elektrisch leitenden Kontakt-Elemente (134) Einpressstifte umfassen, die mit der Schaltungsträger-Einheit (124) verbunden sind.

10. Elektronische Komponente nach einem der vorangehenden Ansprüche, wobei das Gehäuse (104) einen Basis-Körper (112) sowie ein Abdeck-Element (114) umfasst und das Abdeck-Element (114) so an dem Basis-Körper (112) angebracht ist, dass die Schaltungsträger-Einheit (124) abgedichtet eingeschlossen ist.

11. Elektronische Komponente nach einem der vorangehenden Ansprüche, wobei das wenigstens eine elektronische Element (146) ein Leistungsschalt-Element umfasst.

12. Elektronische Komponente nach einem der vorangehenden Ansprüche, wobei das Gehäuse (104) wenigstens teilweise mit einer Vergussmasse gefüllt ist, die wenigstens einen Teil der Schaltungsträger-Einheit (124) abdeckt.

13. Verfahren zum Montieren einer elektronischen Komponente nach einem der vorangehenden Ansprüche, wobei das Verfahren die folgenden Schritte umfasst:
Bereitstellen einer Schaltungsträger-Einheit (124), wobei wenigstens ein elektronisches Element (146) an der Schaltungsträger-Einheit (124) montiert ist,
Bereitstellen eines Schutzgehäuses (104), sowie
Einführen der Schaltungsträger-Einheit (124) wenigstens teilweise in das Gehäuse (104), wobei die Schaltungsträger-Einheit (124) einen ersten Teilabschnitt (128) sowie einen zweiten Teilabschnitt (130) aufweist, und der zweite Teilabschnitt (130) in einem Abstand zu dem ersten Teilabschnitt (128) angeordnet ist und dem ersten Teilabschnitt (128) gegenüberliegt; und
das Gehäuse (104) einen ersten Aufnahmeabschnitt (142) zum Aufnehmen des ersten Teilabschnitts (128) sowie einen zweiten Aufnahmeabschnitt (144) zum Aufnehmen des zweiten Teilabschnitts (130) aufweist,
und der erste Aufnahmeabschnitt (142) und der zweite Aufnahmeabschnitt (144) durch einen Kühl-Zwischenraum (106) voneinander getrennt sind.

14. Verfahren nach Anspruch 13, wobei der erste Teilabschnitt (128) sowie der zweite Teilabschnitt (130) gleichzeitig in den ersten und den zweiten Aufnahmeabschnitt (142, 144) eingeführt werden.

## Revendications

1. Composant électronique (100) comprenant :
une unité porte-circuit (124), dans lequel au moins un élément électronique (146) est assemblé sur l'unité porte-circuit (124), et
un boîtier de protection (104) pour entourer au moins en partie l'unité porte-circuit (124),
dans lequel l'unité porte-circuit (124) comporte une première section (128) et une deuxième section (130),
la deuxième section (130) étant agencée à distance de la première section (128) et opposée à la première section (128),
dans lequel le boîtier (104) comporte une première portion de réception (142) pour recevoir la première section (128) et une deuxième portion de réception (144) pour recevoir la deuxième section (130), et dans lequel la première portion de réception (142) et la deuxième portion de réception (144) sont séparées l'une de l'autre par un intervalle de refroidissement (106), et
**caractérisé en ce que** l'intervalle de refroidissement (106) est formé par au moins une cavité borgne avec une région inférieure fermée et une ouverture (108) pour le passage d'un fluide de refroidissement, dans lequel ladite au moins une cavité borgne présente au moins une ouverture de ventilation (110) qui est agencée à distance de l'ouverture (108).

2. Composant électronique selon la revendication 1, dans lequel l'unité porte-circuit (124) comprend en outre une section de base (126) connectant la première section (128) et la deuxième section (130).

3. Composant électronique selon la revendication 2, dans lequel l'unité porte-circuit (124) comprend en outre des éléments de charnière flexibles (132) connectant la section de base (126) à la première section (128) et/ou à la deuxième section (130).

4. Composant électronique selon la revendication 2 ou 3, dans lequel l'unité porte-circuit (124) comporte une section transversale en forme de U, la première section (128) et la deuxième section (130) formant respectivement une première et une deuxième branche s'étendant à partir de la section de base (126), et dans lequel la première portion de réception (142) et la deuxième portion de réception (144) sont formées par deux fentes parallèles.

5. Composant électronique selon l'une des revendications précédentes, dans lequel l'unité porte-circuit (124) comprend un circuit imprimé, PCB - Printed Circuit Board, et/ou un circuit imprimé flexible, FPC - Flexible Printed Circuit, et/ou un substrat céramique à liaison directe en cuivre, DCB - Direct Copper Bonded, et /ou un substrat céramique à liaison directe en aluminium, DAB - Direct Aluminum Bonded.

6. Composant électronique selon l'une quelconque des revendications précédentes, comprenant en outre une pluralité de nervures de refroidissement (152) qui s'étendent le long de ladite au moins une cavité borgne depuis l'ouverture vers la région inférieure.

7. Composant électronique selon l'une des revendications précédentes, comprenant en outre une interface de connecteur (102) pour entrer en contact électrique avec ledit au moins un élément électronique (146) .

8. Composant électronique selon la revendication 7, dans lequel l'interface de connecteur (102) comprend une pluralité d'éléments de contact électroconducteurs (134).

9. Composant électronique selon la revendication 8, dans lequel les éléments de contact électroconducteurs (134) comprennent des broches frettées qui sont connectées à l'unité porte-circuit (124).

10. Composant électronique selon l'une des revendications précédentes, dans lequel le boîtier (104) comprend un corps de base (112) et un élément de couvercle (114), dans lequel l'élément de couvercle (114) est attaché au corps de base (112) de sorte que l'unité porte-circuit (124) est enfermée de manière étanche.

11. Composant électronique selon l'une des revendications précédentes, dans lequel ledit au moins un élément électronique (146) comprend un élément de commutation de puissance.

12. Composant électronique selon l'une des revendications précédentes, dans lequel le boîtier (104) est au moins partiellement rempli d'un matériau d'enrobage qui recouvre au moins une partie de l'unité porte-circuit.

13. Procédé d'assemblage d'un composant électronique selon l'une des revendications précédentes, le procédé comprenant les étapes suivantes :
fourniture d'une unité porte-circuit (124), dans lequel au moins un élément électronique (146) est assemblé sur l'unité porte-circuit (124),
fourniture d'un boîtier de protection (104), et
insertion au moins partielle de l'unité porte-circuit (124) dans le boîtier (104),
dans lequel l'unité porte-circuit (124) comporte une première section (128) et une deuxième section (130), la deuxième section (130) étant agencée à distance de la première section (128) et opposée à la première section (128) ; et
dans lequel le boîtier (104) comporte une première portion de réception (142) pour recevoir la première section (128) et une deuxième portion de réception (144) pour recevoir la deuxième section (130), et dans lequel la première portion de réception (142) et la deuxième portion de réception (144) sont séparées l'une de l'autre par un intervalle de refroidissement (106).

14. Procédé selon la revendication 13, dans lequel la première section (128) et la deuxième section (130) sont insérées simultanément dans les première et deuxième portions de réception respectives (142, 144).
